# EUROPÄISCHE PATENTSCHRIFT

(11) **EP 3 335 060 B1**
(45) Veröffentlichungstag und Bekanntmachung des Hinweises auf die Patenterteilung: **03.02.2021**
(21) Anmeldenummer: 16756648.8
(22) Anmeldetag: 12.08.2016
(51) Int. Cl.: G01T 1/17, G01N 15/06, H03K 5/1534, G01N 15/00

(54) **VERFAHREN UND VORRICHTUNG ZUR DETEKTION VON SIGNALPULSEN**
METHOD AND DEVICE FOR DETECTING SIGNAL PULSES
PROCÉDÉ ET DISPOSITIF DE DÉTECTION D'IMPULSIONS DE SIGNAUX

(30) Priorität: 12.08.2015 AT 507162015
(43) Veröffentlichungstag der Anmeldung: 20.06.2018
(73) Patentinhaber: AVL List GmbH, 8020 Graz (AT)
(72) Erfinder: BRUNNHOFER, Georg, 8010 Graz (AT)
(74) Vertreter: Patentanwälte Pinter & Weiss OG
(86) Internationale Anmeldenummer: PCT/EP2016/069193
(87) Internationale Veröffentlichungsnummer: WO 2017/025619

(56) Entgegenhaltungen:
- WO-A1-93/22692
- WO-A1-2007/065179
- DE-A1- 3 635 477
- JP-A- H05 149 866
- US-A- 4 803 701

## Beschreibung

Die Erfindung betrifft eine Vorrichtung zur Detektion von Signalpulsen in einem analogen Messsignal eines Partikelzählers, wobei die Vorrichtung einen AD-Wandler und eine Auswerteeinheit aufweist. Weiters betrifft die Erfindung die Verwendung dieser Vorrichtung und ein Verfahren zur Detektion von Signalpulsen in einem analogen Messsignal mit einer solchen Vorrichtung.

Partikelzähler weisen im Allgemeinen einen Lichtteppich auf, durch den ein meist vereinzelter Partikelstrom geführt wird, wobei jedes Partikel beim Passieren des Lichtteppichs Streulicht erzeugt, das von einem Lichtsensor detektiert wird. Um die Messbarkeit zu verbessern durchlaufen die Partikel üblicherweise zuvor eine Kondensationseinheit, in der Kondensationströpfchen an Partikeln anwachsen. Aufgrund der höheren Größe und der Einheitlichkeit der Kondensationströpchens wird die Zählbarkeit gegenüber einer direkten Messung der Partikel ermöglicht.

Durch die gaußförmige Lichtintensitätsverteilung des Lichtteppichs erzeugt ein passierendes Partikel einen ebenso gaußförmigen Signalpuls. Im Optimalfall liefert jedes Einzelpartikel einen einzelnen Streulichtpuls, was einen zeitlichen Verlauf von sporadisch auftretenden Signalpulsen entspricht. Die statistische Wahrscheinlichkeitsverteilung von diskreten Ereignissen lässt sich dabei über eine Poisson-Verteilung ermitteln.

Ist die zeitliche Distanz zwischen Partikeln zu gering, tritt Koinzidenz auf. Dabei überlagern sich die von den knapp hintereinander folgenden Partikeln erzeugten Signalpulse signaltechnisch zu einem einzigen Signalpuls und können nicht mehr als zwei Einzelereignisse separiert werden.

Der Lichtsensor erzeugt ein analoges Messsignal, das zur Detektion und Zählung der Signalpulse ausgewertet wird. Üblicherweise wird dabei ein Schwellenwert definiert, wobei der erzeugte Signalpuls eines passierenden Partikels von einem Komparatorglied erfasst wird und das Partikel als erkannt gilt, wenn dieser Schwellenwert überschritten wird. Bei einem zu hoch gewählten Schwellenwert kann es passieren, dass zu kleine Signalpulse fälschlicherweise nicht gezählt werden. Wird der Schwellenwert jedoch zu niedrig gewählt, werden eng zusammenliegende, sich teilweise überschneidende Signalpulse (Koinzidenzen) als nur ein einzelner Signalpuls erkannt, und daher werden manche Signalpulse nicht detektiert. Auch Hintergrundrauschen kann bei einem zu niedrigen Schwellenwert zu falschen Ergebnissen führen.

Besonders nachteilig ist es, wenn das gemessene Pulsensemble ein Driftverhalten aufweist, sodass sich besagtes Ensemble während der Messung aus dem durch den Schwellenwert definierten Messbereich hinausbewegt. Die Signalauswertung über Schwellenwerte kann hier unbemerkt zu einem falschen Ergebnis führen.

Die Signalauswertung wird üblicherweise in der analogen Domäne durchgeführt, da die Signalpulse im Messsignal sehr kurz sind, üblicherweise im Bereich von 80 - 200 ns, sodass eine Digitalisierung eine sehr hohe Abtastrate erfordert. Zwar sind AD-Wandler verfügbar, die eine ausreichend hohe Abtastrate auch für sehr kurze Signalpulse ermöglichen, die Auswertung mittels Schwellenwerten in der digitalen Domäne hat jedoch keine wesentlichen Vorteile gegenüber der analogen Domäne, sodass im Allgemeinen eine Auswertung in der analogen Domäne die einfachere und daher bevorzugte Lösung darstellt.

DE 3635477 A1 offenbart Verfahren und eine Schaltungsanordnung zur Zählung von Impulsen eines Detektors zur Argon-Datierung von Proben, insbesondere zur Radiohydrometrie, wobei die verstärkten Impulse vom Detektor einem Analog-Digitalumsetzer zugeführt werden. Das digitalisierte Signal wird einem PC-System übergeben, in welchem eine an der Art, Form oder Steigung des detektierten Impulses orientierte Unterscheidung der gespeicherten Detektorimpulse vorgenommen wird.

WO 93/022692 A1 offenbart einen Szintillationszähler mit einer Vielzahl an Photoelektronenvervielfachern (PMTs). Die Signale der PMTs werden summiert und in ein digitales Signal umgewandelt. Aus dem digitalen Signal werden mittels einer Steigungsanalyse Zählereignisse registriert.

Es besteht im Stand der Technik ein Bedarf an Vorrichtungen und Verfahren zur Detektion von Signalpulsen, die eine bessere Erkennung von Koinzidenzen und eine höhere Zählgenauigkeit ermöglichen, und die eine Möglichkeit bieten, ein Driftverhalten des Messsignals zu erkennen, zu bewerten und auszugleichen.

Diese und weitere Aufgaben des Standes der Technik werden erfindungsgemäß durch eine Vorrichtung der eingangs genannten Art gelöst, bei der die Auswerteeinheit eine Steigungsauswerteeinheit aufweist, die Signalpulse durch Auswertung der Steigungen zwischen benachbarten Abtastungen im digitalen Datenstrom des AD-Wandlers in Echtzeit ermittelt, wobei die Auswerteeinheit eine Driftdetektionseinheit aufweist, die Kriterien zur Detektion und/oder Bewertung des Driftverhaltens des Messsignals ermittelt und auswertet. Mit anderen Worten ermöglicht die Erfindung also eine Vorrichtung bzw. ein Verfahren zur Detektion und Zählung von teilweise überlagernden Signalpulsen in einem analogen Messsignal eines Partikelzählers. Anstelle fixer Schwellenwerte kann dadurch der Verlauf des Messsignals auf einfache Weise ausgewertet werden. Steigungswechsel können zur Erkennung von Pulsspitzen ausgewertet werden. Dies erlaubt es auch, ein Driftverhalten zu erkennen und auszugleichen. Eine Auswertung in Echtzeit ist bei kontinuierlichen Messverfahren erforderlich und kann durch die erfindungsgemäße Vorrichtung erzielt werden.

In einer vorteilhaften Ausführungsform der Erfindung erstellt der AD-Wandler den digitalen Datenstrom mit einer Abtastrate von über 50 MSPS (Millionen Samples pro Sekunde bzw. Megasamples per Second), vorzugsweise zwischen 50 und 105 MSPS. Dies erlaubt bereits eine Detektion von Signalpulsen im Nanosekundenbereich.

Bevorzugter Weise kann die Detektion von Signalpulsen erfindungsgemäß in einem integrierten Schaltkreis, vorzugsweise einem Field-Programmable-Gate-Array, implementiert sein. Dies erlaubt eine hardwarenahe und dennoch flexible Implementierung der Erkennungsalgorithmen und ermöglicht dadurch auf einfache Weise eine Signalauswertung in Echtzeit.

In einer weiteren vorteilhaften Ausgestaltung der Erfindung kann die Auswerteeinheit eine Detektiereinheit aufweisen, die einen Signalpuls detektiert, wenn eine Abfolge an Abtastungen die Bedingungen eines Parametersatzes erfüllen, wobei der Parametersatz zumindest einen Parameter, ausgewählt aus minimalem Flankenanstieg, minimaler Steigungsdauer und/oder minimalem Flankenabfall umfasst. Ein solcher Parametersatz erlaubt eine schnelle Detektion von Signalpulsen anhand einfacher vergleichender Rechenoperationen. Integrier- oder Differenzierglieder sind dabei nicht erforderlich.

Um Hintergrundrauschen auszufiltern, kann die Auswerteeinheit in vorteilhafter Weise eine Schwelleneinheit aufweisen, die Abtastungen bei Unterschreiten einer definierten Detektionsschwelle von der Auswertung ausscheidet.

In einer weiteren Ausführungsform kann die Auswerteeinheit eine Driftdetektionseinheit aufweisen, die Kriterien zur Detektion und/oder Bewertung des Driftverhaltens des gemessenen Pulsensembles ermitteln und auswertet. Dadurch können Fehlerquellen frühzeitig erkannt und Minderbefunde vermieden werden.

In bevorzugter Weise können erfindungsgemäß die Kriterien zur Detektion und/oder Bewertung des Driftverhaltens eine Änderung des Hintergrundlichts, eine durchschnittliche Signalpulsamplitude und/oder eine durchschnittliche Signalpulsdauer umfassen. Derartige Kriterien erlauben eine qualifizierte Aussage über die Ursachen eines auftretenden Driftverhaltens, sodass entsprechende Wartungsmaßnahmen rechtzeitig eingeplant werden können.

In vorteilhafter Weise kann die Vorrichtung ein Kompensationsglied zum Ausgleich eines Driftverhaltens im Partikelzähler aufweisen, wobei eine Regelgröße des Kompensationsglieds zur Detektion und/oder Bewertung des Driftverhaltens des Messsignals an die Auswerteeinheit übermittelt wird. Insbesondere eine Änderung des Hintergrundlichts in der Messzelle kann mit dem Kompensationsglied ausgeglichen werden, wobei das Kompensationsglied in der analogen Domäne oder in der digitalen Domäne vorgesehen sein kann. Der Ausgleich des Driftverhaltens stellt sicher, dass sich die Nullinie des Messsignals nicht verlagert. Dadurch wird etwa die Wirksamkeit der Detektionsschwelle zum Ausfiltern von Hintergrundrauschen gewährleistet. Gleichzeitig wird die Regelgröße von der Auswerteeinheit als eines der Kennwerte für die Detektion und/oder Bewertung von Driftverhalten verwendet.

Alle Vorrichtungselemente, insbesondere der AD-Wandler, die Auswerteeinheit, die Steigungsauswerteeinheit, die Detektiereinheit, die Schwelleneinheit, die Driftdetektionseinheit, und/oder das Kompensationsglied, sowie alle weiteren Funktionellen Elemente der Vorrichtung können, je nach Erfordernis, als jeweils eigene Hardwareeinheit ausgeführt sein, sie können zu beliebig zu Hardwareeinheiten in Untergruppen beliebig kombiniert werden, sie können jeweils in andere Einheiten integriert sein, oder sie können teilweise oder als Gesamtheit softwaretechnisch implementiert sein.

Die erfindungsgemäße Vorrichtung kann in vorteilhafter Weise dazu verwendet werden, dass auf Basis eines Driftverhaltens ein Wartungszeitpunkt ermittelt wird. Dabei können anhand der jeweiligen Kriterien auch konkrete Aussagen über die Art der erforderlichen Wartung abgeleitet werden.

Das eingangs genannte Verfahren zur Detektion von Signalpulsen in einem analogen Messsignal sieht vor, dass Signalpulse durch Auswertung der Steigungen zwischen benachbarten Abtastungen im digitalen Datenstrom des AD-Wandlers in Echtzeit ermittelt werden, wobei Kriterien zur Detektion und/oder Bewertung des Driftverhaltens des Messsignals ermittelt und ausgewertet werden.

In vorteilhafter Weise kann das Verfahren einen Signalpuls detektieren, wenn eine Abfolge an Abtastungen die Bedingungen eines Parametersatz erfüllen, wobei der Parametersatz zumindest einen Parameter umfasst, der ausgewählt ist aus minimalem Flankenanstieg (min_incr), minimaler Steigungsdauer (peak_valid) und/oder minimalem Flankenabfall (min_decr).

Gegebenenfalls können auch mehrere unterschiedliche Parametersätze parallel ausgewertet und verglichen werden, beispielsweise zur dynamischen Bestimmung des optimalen Parametersatzes hinsichtlich Zählgenauigkeit, zur Kategorisierung von Partikeleigenschaften oder zur Ermittlung von Koinzidenzen. Die parallelen Parametersätze können beispielsweise für eine automatische Korrektur verwendet werden.

In vorteilhafter Weise werden dabei erfindungsgemäß Abtastungen nur bei Überschreiten einer definierten Detektionsschwelle ausgewertet, um Hintergrundrauschen auszufiltern.

In einer bevorzugten Ausgestaltung des erfindungsgemäßen Verfahrens können die Kriterien zur Detektion und/oder Bewertung des Driftverhaltens vorzugsweise eine Änderung des Hintergrundlichts, eine durchschnittliche Signalpulsamplitude und/oder eine durchschnittliche Signalpulsdauer umfassen.

In vorteilhafter Weise kann das minimale Verhältnis von durchschnittlicher Signalpulsdauer zu Abtastintervall weniger als 40, bevorzugt weniger als 20 und insbesondere weniger als 6 betragen. Aufgrund des stabilen Auswertealgorithmus lassen sich Signalpulse auch anhand einiger weniger Abtastungen zuverlässig erkennen. Dies erhöht auch die maximal zulässige Durchtrittsgeschwindigkeit der Partikel. Mit dem erfindungsgemäßen Verfahren können beispielsweise bei einer Abtastfrequenz von 100 MSPS Signalpulse von nur 30 ns Dauer erkannt werden. Dies entspricht einem Verhältnis von Signalpulsdauer (3^{∗}10⁻⁸ s) zu Abtastintervall (1^{∗}10⁻⁸ s) von 3. Für eine ausreichende und aussagekräftige Bewertung des Driftverhaltens durch die durchschnittliche Signalpulsamplitude bzw. der durchschnittlichen Signalpulsdauer kann eine höhere Abtastfrequenz sinnvoll sein.

Zur Detektion teilweise überlagernder Signalpulse können Abweichungen von der idealen Signalform quantifiziert und in weiterer Folge berücksichtigt werden. Das Maß der Abweichung von der idealen Signalform lässt Rückschlüsse auf auftretende Koinzidenz zu.

Die gegenständliche Erfindung wird nachfolgend unter Bezugnahme auf die Figuren 1 bis 3 näher erläutert, die beispielhaft, schematisch und nicht einschränkend vorteilhafte Ausgestaltungen der Erfindung zeigen. Dabei zeigt
Fig.1 ein analoges Messsignal mit mehreren Signalpulsen,
Fig. 2 ein Blockdiagramm einer erfindungsgemäßen Vorrichtung zur Detektion von Signalpulsen mit einer Detektoreinheit und einer Auswerteeinheit und
Fig. 3 ein Diagramm eines digitalisierten Signalpulsensembles zur Erläuterung der Parameter für den Auswertealgorithmus

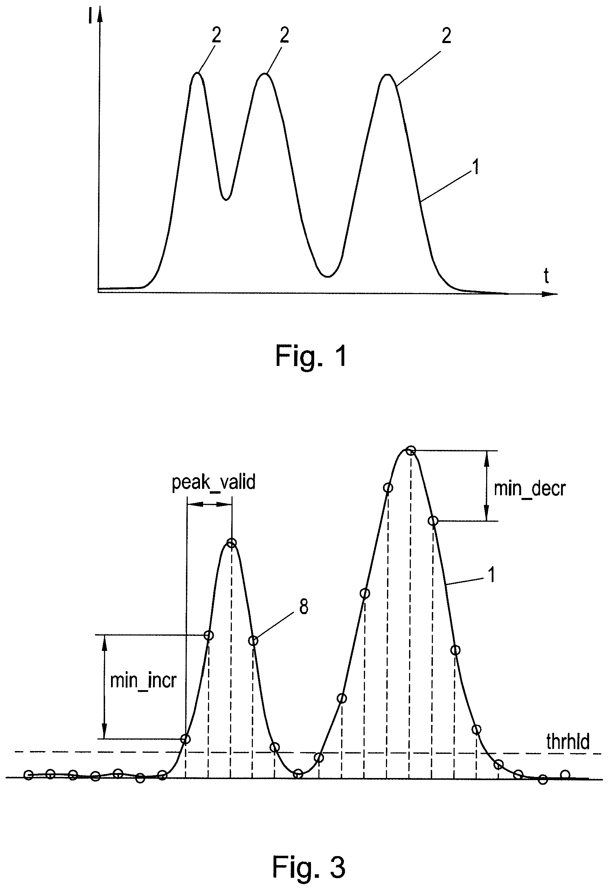

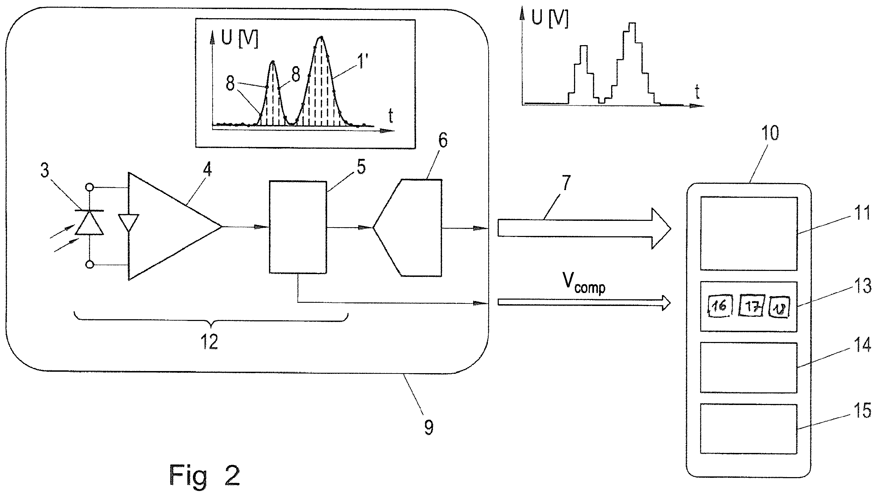

Fig. 1 zeigt den Verlauf eines von einem Photodetektor aufgezeichneten Messsignals 1, wobei die Lichtintensität l über der Zeit t eingezeichnet ist. Das Messsignal kann beispielsweise von einer Sensorzelle eines Kondensationspartikelzählers stammen, wobei jeder der drei im Messsignal 1 dargestellten Signalpulse 2 von einem durch den Lichtteppich der Messzelle hindurchtretenden Partikel erzeugt wurde. Wenn das Partikel, bzw. das auf dem Partikel aufkondensierte Aerosoltröpfchen einen Lichtteppich durchquert, trifft das vom Partikel gestreute Licht auf den Photodetektor 3 (siehe Fig. 2) und erzeugt einen Signalpuls 2. In Fig. 1 zeigen die ersten beiden Signalpulse 2 eine beginnende Überlagerung, wie sie bei sehr geringer zeitliche Aufeinanderfolge auftreten kann.

Die Dauer solcher Signalpulse liegt - bestimmt durch die Partikel(end)größe und die Breite des Lichtteppichs - typischerweise im Bereich von wenigen Nanosekunden, beispielsweise im Bereich von 80 bis 200 ns.

Die Höhe des Signalpulses steht mit der Streulichtintensität und somit mit der Partikelgröße in Zusammenhang. Die Pulsbreite gibt Aufschluss über die Zeitdauer, die das Partikel benötigt, um den Lichtvorhang bzw. die optische Detektionseinrichtung zu durchqueren.

Fig. 2 zeigt ein Ausführungsbeispiel einer erfindungsgemäßen Vorrichtung. Die Vorrichtung weist eine Detektoreinheit 9 mit einem Photodetektor 3, einem Transimpedanzverstärker 4, einem Kompensationsglied 5, und einem AD-Wandler 6, und eine Auswerteeinheit 10 mit einem Field-Programmable-Gate-Array 11 auf.

Der vom Photodetektor 3 erzeugte Strom (d.h. das Messsignal 1) wird mit dem Transimpedanzverstärker 4 verstärkt und dabei in ein Spannungssignal 1' umgewandelt, bevor es durch den AD-Wandler digitalisiert wird. Das Spannungssignal 1' ist in Fig. 2 in einem Diagramm oberhalb des Kompensationsglieds 5 dargestellt, wobei die Abtastungen 8 für die Digitalisierung schematisch eingezeichnet sind. Das Spannungssignal kann in bekannter Weise vor der AD-Wandlung einer Antialiasingfilterung unterzogen werden.

Die geringe Dauer der Signalpulse im Nanosekundenbereich erfordert bei einer Digitalisierung des Signals eine sehr schnelle Abtastung, eine schnelle digitale Signalauswertealgorithmik und eine dementsprechend hohe Bandbreite des analogen Signalpfades. Dazu kann beispielsweise als Photodetektor 3 ein High Speed Photodetektor mit hoher Bandbreite verwendet werden. Abgestimmt dazu muss der nachgeschaltete Transimpedanzverstärker 4 eine ausreichend hohe Verstärkung aufweisen. Hierbei muss darauf geachtet werden, dass mit einem ausreichend hohem Gainbandwidth Produkt die ebenso nötige Signalbandbreite gewährleistet ist (je höher der Gain eines Verstärkers, desto limitierter ist dessen Bandbreite).

Das Kompensationsglied 5 gleicht Hintergrundlichtschwankungen in der Detektionskammer aus. Die vom Kompensationsglied 5 verwendete Regelgröße V_{comp} wird weiters an die Auswerteeinheit 10 weitergeleitet und dient als eines von mehreren Kriterien zur Drifterkennung. Mit zunehmender Änderung des Hintergrundlichtes kann auf Verschmutzung bzw. Dekalibration des Messsystems geschlossen werden. Die Drifterkennung wird weiter unten eingehender beschrieben.

Die Signalleitung vom Transimpedanzverstärker 4, bzw. dem Kompensationsglied 5 zum AD-Wandler 6 kann vorzugsweise über ein differentielles Leitungspaar aufgebaut sein, welches zusätzlich für Signalintegrität gegenüber elektromagnetischer Einkopplung sorgt.

Die Abtastfrequenz kann vorzugsweise im Bereich von 50MHz bis 105MHz liegen, um eine ausreichend hohe Auflösung der Signalpulse für die nachfolgende Signalauswertung zu gewährleisten.

Das digitalisierte Signal wird als digitaler Datenstrom 7 an die Auswerteeinheit 10 weitergeleitet. Da die Partikelzählung auf Basis einer kontinuierlichen Detektion von Signalpulsen beruht, müssen diese von der Auswerteeinheit 10 in Echtzeit erkannt und bewertet werden. Hauptanforderungen an die Auswerteeinheit 10 sind daher vor allem eine schnelle Datenakquisition und folglich die Sicherstellung der Echtzeitfähigkeit des Auswertealgorithmus. Sowohl das Einlesen der Abtastungen des AD-Wandlers mit einer Abtastrate fₛ von 50 MSPS bis 105 MSPS, als auch die Detektion und Bewertung der Streulichtpulse werden daher in einem Field-Programmable-Gate-Array (FPGA) 11 verarbeitet.

Die von der Auswerteeinheit 10 ausgeführten Funktionen können eine Signalpulserkennung und -bewertung 13, einen Zählalgorithmus 14 und eine Driftdetektionseinheit 15 zur Drifterkennung und -bewertung umfassen. Diese Funktionseinheiten können entweder direkt im FPGA 11 oder in einer diesem nachgelagerten Einheit implementiert sein. Gegebenenfalls kann die Auswerteeinheit 10 auch auf andere Weise (etwa ohne ein FPGA) ausgeführt sein, solange die gewählten Mittel eine ausreichende Prozessierungsgeschwindigkeit gewährleisten. Die Signalimpulserkennung und -bewertung 13 weist weiters eine Steigungsauswerteeinheit 16 zur Auswertung der Steigungen zwischen benachbarten Abtastungen, eine Detektiereinheit 17 zur Detektion von Signalimpulsen auf Basis von Parametersätzen, und eine Schwelleneinheit 18 auf. Die Schwelleneinheit 18 stellt sicher, dass Abtastungen nur bei Überschreiten einer definierten Detektionsschwelle ausgewertet werden.

Aufgrund der Anforderung auf schnelle Verarbeitung und Echtzeitfähigkeit des Auswertealgorithmus, muss die mathematische Komplexität gering gehalten werden. Um die Signalpulse zu detektieren und voneinander separieren zu können, kann der FPGA 11 verschiedene Parameter bzw. mit diesen Parametern verknüpfte Bedingungen auswerten und dadurch ein Ausgangssignal (oder mehrere Ausgangssignale) erzeugen, das dann zur Zählung und weiteren Auswertung verarbeitet werden kann.

In Fig. 3 sind einige Parameter anhand eines digitalen Messsignals 1 beispielhaft dargestellt:

### 1. Detektionsschwelle (thrhld)

Um den Rauschanteil des Systems der digitalen Signalauswertung auszublenden, wird die Detektionsschwelle als Schwellenwert eingeführt, über dem die Detektion eines Signalpulses beginnt. Die durch die Detektionsschwelle festgelegte Bedingung lässt sich für jede einzelne Abtastung ohne Berücksichtigung benachbarter Abtastungen ermitteln. Es ist zu beachten, dass sich die Detektionsschwelle in Ihrer Funktion von einem Schwellenwert, wie er im Stand der Technik zur Erzeugung eines Zählereignisses verwendet wird, unterscheidet, da die Detektionsschwelle nicht als ausschließliches Kriterium für die Partikelzählung herangezogen wird.

### 2. Minimaler Flankenanstieg (min_incr)

Als Kenngröße für den Anstieg eines Signalpulses und somit auch für dessen Frequenz dient ein Parameter, der den minimalen Signalanstieg zwischen zwei aufeinanderfolgenden Datenpunkten festlegt. Sobald die Steigung zwischen aufeinanderfolgenden Abtastungen oberhalb des minimalen Signalanstiegs liegt, ist die erste Bedingung zur Detektion eines Signalpulses erfüllt. Zur Auswertung dieses Parameters (bzw. der damit verbundenen Bedingung) ist die Ermittlung der Steigung zwischen zwei Abtastungen erforderlich. Anhand eines einzelnen Wertes einer Abtastung kann keine Aussage in Bezug auf diesen Parameter getroffen werden.

### 3. Minimale Steigungsdauer (peak_valid)

Neben dem Wert der Steigung ist auch die Amplitude eines Signalpulses relevant für die korrekte Detektion des Signalpulses. Der Parameter der minimalen Steigungsdauer definiert eine Mindestanzahl an stetig steigenden Datenpunkten, die ein Signalverlauf aufweisen muss, um als Signalpuls detektiert zu werden. In Kombination dienen die anhand der Parameter des minimalen Flankensteigungs (min_incr) und der minimalen Steigungsdauer (peak_valid) überprüften Bedingungen auch als Tiefpassfilter. Signalspitzen, die aus überlagertem Rauschen entstehen werden dabei herausgefiltert.

### 4. Minimaler Flankenabfall (min_decr)

Um einen Signalpuls korrekt zu detektieren, muss weiters ermittelt werden, ob er eine Wertspitze erreicht hat. Eine Wertspitze ist dann erreicht, wenn auf den Anstieg ein Abfall folgt, der den Wert für einen minimalen Flankenabfall unterschreitet. Der minimale Flankenabfall (min_decr) stellt somit das Gegenstück zum minimalen Flankenanstieg (min_incr) dar. Diesem Parameter (bzw. dieser Teilbedingung) kommt bei der Separierung zeitlich eng aufeinanderfolgender oder teils überlagerter Signalpulse eine besondere Wichtigkeit zu.

Anhand der Parameter wird ein Parametersatz erstellt, der als Bedingung für die Detektion eines Signalpulses erfüllt sein muss. Zum Auffinden des optimalen Parametersatzes muss ein Kompromiss zwischen Zählgenauigkeit, Schnelligkeit der Auswertung und Rauschempfindlichkeit gefunden werden. Ein einfacher Parametersatz wäre 1x min_incr + 1x min_decr. Dies würde eine Signalpulserkennung innerhalb von nur drei Abtastungen erlauben.

Es wäre auch eine Kombination der Parameter min_inc und peak_valid als Minimalbedingung möglich. Sind die Parameter min_inc und peak_valid hoch genug gewählt, wird der Rauschteppich ausgeblendet und relevante Signalpulse werden richtig erkannt, sofern diese nicht zu stark verrauscht sind. Wenn auch der Parameter min_decr berücksichtigt wird, ergibt sich eine zusätzliche Tiefpassfilterfunktion.

Ein Parametersatz, der zur Ermittlung von Signalpulsen alle obigen Parameter heranzieht, könnte also als Bedingung für die Detektion eine Abfolge von Abtastwerten oberhalb der Detektionsschwelle definieren, bei denen in einer stetigen Abfolge von Steigungen zumindest einmal der minimale Flankenanstieg überschritten wird, die Anzahl der Steigungen die minimale Steigungsdauer übersteigt, und bei der nach dem Maximalwert zumindest eine (negative) Steigung den minimalen Flankenabfall unterschreitet. Weiters könnte definiert werden, in welchem Zeitraum dieser Flankenabfall unterschritten werden muss.

Es können anhand der Steigungswerte auch weitere Parameter definiert werden (zum Beispiel eine minimale Dauer für den Flankenabfall, analog zum Wert peak_valid), die zur Auswertung des Signals zu einem Parametersatz zusammengesetzt werden.

Gegebenenfalls können auch mehrere Parametersätze parallel ausgewertet werden, um Korrekturfaktoren zu ermitteln, etwa zur Erkennung von Koinzidenzen.

Das erfindungsgemäße Verfahren erlaubt weiters eine einfache Detektion und Bewertung des Driftverhaltens der Messvorrichtung. Das Driftverhalten kann anhand mehrerer Kriterien beurteilt werden, zu denen die Änderung des Hintergrundlichts V_{comp}, die durchschnittliche Signalpulsamplitude Aₚₑₐₖ und die durchschnittliche Signalpulsdauer Tₚₑₐₖ zählen.

Eine Änderung des Hintergrundlichtes V_{comp} kann auf ein De-Kalibration der Detektoreinheit und/oder der Lichtquelle hinweisen. Dabei ist das Hintergrundlicht ein wichtiger Parameter für die Bestimmung von Wartungsintervallen. Das Hintergrundlicht kann beispielsweise über den Regelparameter des Kompensationsglieds 5 überwacht werden.

Die durchschnittliche Signalpulsamplitude Aₚₑₐₖ wird insbesondere von der Partikelgröße beeinflusst. In Kondensationspartikelzählern wachsen Partikel auf eine bestimmte und konstante Größe auf, bevor sie die optische Detektionseinheit (d.h. die Messzelle der Messvorrichtung) passieren. Die Strahlform des Lichtteppichs und Variationen des Streuwinkels können zwar zu Abweichungen der einzelnen Streulichtpulse führen, im Mittel bilden die Partikel jedoch Streulichtpulse mit annähernd gleichbleibender Intensität auf den Photodetektor ab. Aus Signalsicht bedeutet dies eine durchschnittlich konstante Pulsamplitude. Änderungen der Streulichtintensität lassen daher Rückschlüsse auf eine schlechter werdende Aufwachsqualität des Betriebsmittels im Kondensor zu.

Die durchschnittliche Signalpulsdauer Tₚₑₐₖ ist ein Maß für die Verweildauer der Partikel im Lichtteppich. Eine längere durchschnittliche Signalpulsdauer Tₚₑₐₖ weist auf länger im Lichtteppich verweilende Partikel hin, was auf Verschmutzung der Messkammer, oder Änderung der Betriebsmittelströmung, oder Änderung des Lichtteppichs hinweist. Die Auswertung dieses Wertes ist wesentlich für die Bestimmung von Wartungsintervallen.

### Bezugszeichen:

Messsignal 1
Signalpulse 2
Photodetektor 3
Transimpedanzverstärker 4
Kompensationsglied 5
AD-Wandler 6
digitaler Datenstrom 7
Abtastung 8
Detektoreinheit 9
Auswerteeinheit 10
Field-Programmable-Gate-Array (FPGA) 11
Analoger Signalpfad 12
Signalpulserkennung und -bewertung 13
Zählalgorithmus 14
Driftdetektionseinheit 15
Steigunsauswerteeinheit 16
Detektiereinheit 17
Schwelleneinheit 18

## Patentansprüche

1. Vorrichtung zur Detektion von Signalpulsen (2) in einem analogen Messsignal (1) eines Partikelzählers, wobei die Vorrichtung einen AD-Wandler (6) und eine Auswerteeinheit (10) aufweist, wobei die Auswerteeinheit (10) eine Steigungsauswerteeinheit (16) aufweist, die Signalpulse (2) durch Auswertung der Steigungen zwischen benachbarten Abtastungen (8) im digitalen Datenstrom (7) des AD-Wandlers (6) in Echtzeit ermittelt, **dadurch gekennzeichnet, dass** die Auswerteeinheit (10) eine Driftdetektionseinheit aufweist, die Kriterien zur Detektion und/oder Bewertung des Driftverhaltens des Messsignals (1) ermittelt und auswertet.

2. Vorrichtung nach Anspruch 1, **dadurch gekennzeichnet, dass** der AD-Wandler (6) den digitalen Datenstrom (7) mit einer Abtastrate (fₛ) von über 50 MSPS, vorzugsweise im Bereich zwischen 50 und 105 MSPS, erstellt.

3. Vorrichtung nach Anspruch 1 oder 2, **dadurch gekennzeichnet, dass** die Detektion von Signalpulsen (2) in einem integrierten Schaltkreis, vorzugsweise einem Field-Programmable-Gate-Array (11), implementiert ist.

4. Vorrichtung nach einem der Ansprüche 1 bis 3, **dadurch gekennzeichnet, dass** die Auswerteeinheit (10) eine Detektiereinheit (17) aufweist, die einen Signalpuls (2) detektiert, wenn eine Abfolge an Abtastungen (8) die Bedingungen eines Parametersatzes erfüllt, wobei der Parametersatz zumindest einen Parameter umfasst, der ausgewählt ist aus minimalem Flankenanstieg (min_incr), minimaler Steigungsdauer (peak_valid) und/oder minimalem Flankenabfall (min_decr).

5. Vorrichtung nach einem der Ansprüche 1 bis 4, **dadurch gekennzeichnet, dass** die Auswerteeinheit (10) eine Schwelleneinheit (18) aufweist, die Abtastungen (8) bei Unterschreiten einer definierten Detektionsschwelle (thrhld) von der Auswertung ausscheidet.

6. Vorrichtung nach einem der Ansprüche 1 bis 5, **dadurch gekennzeichnet, dass** die Kriterien zur Detektion und/oder Bewertung des Driftverhaltens eine Änderung des Hintergrundlichts (V_{comp}), eine durchschnittliche Signalpulsamplitude (Aₚₑₐₖ) und/oder eine durchschnittliche Signalpulsdauer (Tₚₑₐₖ) umfassen.

7. Vorrichtung nach einem der Ansprüche 1 bis 6, **dadurch gekennzeichnet, dass** die Vorrichtung ein Kompensationsglied (5) zum Ausgleich eines Driftverhaltens im Partikelzähler aufweist, wobei eine Regelgröße (V_{comp}) des Kompensationsglieds (5) zur Detektion und/oder Bewertung des Driftverhaltens des Messsignals (1) an die Auswerteeinheit (10) übermittelt wird.

8. Verwendung einer Vorrichtung nach einem der Ansprüche 1 bis 7, **dadurch gekennzeichnet, dass** auf Basis eines Driftverhaltens ein Wartungszeitpunkt ermittelt wird.

9. Verfahren zur Detektion von Signalpulsen (2) in einem analogen Messsignal (1) mit einer Vorrichtung gemäß einem der Ansprüche 1 bis 7, **dadurch gekennzeichnet, dass** die Auswerteeinheit (10) Signalpulse (2) durch Auswertung der Steigungen zwischen benachbarten Abtastungen (8) im digitalen Datenstrom (7) des AD-Wandlers (6) in Echtzeit ermittelt, wobei Kriterien zur Detektion und/oder Bewertung des Driftverhaltens des Messsignals (1) ermittelt und ausgewertet werden.

10. Verfahren nach Anspruch 9, **dadurch gekennzeichnet, dass** ein Signalpuls (2) detektiert wird, wenn eine Abfolge an Abtastungen (8) die Bedingungen eines Parametersatzes erfüllen, wobei der Parametersatz zumindest einen Parameter umfasst, der ausgewählt ist aus minimalem Flankenanstieg (min_incr), minimaler Steigungsdauer (peak_valid) und/oder minimalem Flankenabfall (min_decr).

11. Verfahren nach Anspruch 9 oder 10, **dadurch gekennzeichnet, dass** Abtastungen (8) nur bei Überschreiten einer definierten Detektionsschwelle (thrhld) ausgewertet werden.

12. Verfahren nach einem der Ansprüche 9 bis 11, **dadurch gekennzeichnet, dass** die Kriterien zur Detektion und/oder Bewertung des Driftverhaltens eine Änderung des Hintergrundlichts (V_{comp}), eine durchschnittliche Signalpulsamplitude (Aₚₑₐₖ) und/oder eine durchschnittliche Signalpulsdauer (Tₚₑₐₖ) umfassen.

13. Verfahren nach einem der Ansprüche 9 bis 12, **dadurch gekennzeichnet, dass** das minimale Verhältnis von durchschnittlicher Signalpulsdauer (Tₚₑₐₖ) zu Abtastintervall (tₛ) weniger als 40, bevorzugt weniger als 20 und insbesondere weniger als 6 beträgt.

14. Verfahren nach einem der Ansprüche 9 bis 13, **dadurch gekennzeichnet, dass** zur Detektion teilweise überlagernder Signalpulse Abweichungen von der idealen Signalform quantifiziert und in weiterer Folge berücksichtigt werden.

## Claims

1. A device for detecting signal pulses (2) in an analogue measurement signal (1) of a particle counter, wherein the device comprises an AD-converter (6) and an evaluation unit (10), wherein the evaluation unit (10) includes a slope evaluation unit (16), which determines signal pulses (2) by evaluating the slopes between adjacent samples (8) in the digital data stream (7) of the AD-converter (6) in real time, **characterized in that** the evaluation unit (10) includes a drift detection unit that determines and evaluates criteria for detecting and/or evaluating the drift behavior of the measurement signal (1).

2. The device according to claim 1, **characterized in that** the AD-converter (6) generates the digital data stream (7) at a sampling rate (fₛ) of more than 50 MSPS, preferably in a range between 50 and 105 MSPS.

3. The device according to claim 1 or 2, **characterized in that** the detection of signal pulses (2) is implemented in an integrated circuit, preferably a field programmable gate array (11).

4. The device according to any of claims 1 to 3, **characterized in that** the evaluation unit (10) includes a detection unit (17) that detects a signal pulse (2) if a sequence of samples (8) meets the conditions of a parameter set, wherein the parameter set comprises at least one parameter selected from minimum edge increase (min_incr), minimal increase duration (peak_valid) and/or minimal edge decrease (min_decr).

5. The device according to any of claims 1 to 4, **characterized in that** the evaluation unit (10) includes a threshold unit (18) that excludes samples (8) that fall below a predefined detection threshold (thrhld) from the evaluation.

6. The device according to any of claims 1 to 5, **characterized in that** the criteria for detecting and/or evaluating the drift behavior comprise a change in the background light (V_{comp}), an average signal pulse amplitude (Aₚₑₐₖ) and/or an average signal pulse duration (Tₚₑₐₖ).

7. The device according to any of claims 1 to 6, **characterized in that** the device includes compensation means (5) for compensating a drift behavior in the particle counter, wherein a control variable (V_{comp}) of the compensation means (5) is transferred to the evaluation unit (10) for detecting and/or evaluating the drift behavior of the measurement signal (1).

8. Use of a device according to any of claims 1 to 7, **characterized in that** a maintenance time is determined on the basis of a drift behavior.

9. A method for detecting signal pulses (2) in an analogue measurement signal (1) with a device according to any of claims 1 to 7, **characterized in that** the evaluation unit (10) determines signal pulses (2) by evaluating the slopes between adjacent samples (8) in the digital data stream (7) of the AD-converter (6) in real time, wherein criteria for detecting and/or evaluating the drift behavior of the measurement signal (1) are determined and evaluated.

10. The method according to claim 9, **characterized in that** a signal pulse (2) is detected if a sequence of samples (8) meets the conditions of a parameter set, wherein the parameter set comprises at least one parameter selected from a minimal edge increase (min_incr), a minimal increase duration (peak_valid) and/or a minimum edge decrease (min_decr).

11. The method according to claim 9 or 10, **characterized in that** samples (8) are evaluated only if they exceed a predefined detection threshold (thrhld).

12. The method according to any of claims 9 to 11, **characterized in that** the criteria for detecting and/or evaluating the drift behavior comprise a change in the background light (V_{comp}), an average signal pulse amplitude (Aₚₑₐₖ) and/or an average signal pulse duration (Tₚₑₐₖ).

13. The method according to any of claims 9 to 12, **characterized in that** the minimum ratio between the average signal pulse duration (Tₚₑₐₖ) and the sampling interval (tₛ) is less than 40, preferably less than 20 and in particular less than 6.

14. The method according to any of claims 9 to 13, **characterized in that** for the detection of partially overlapping signal pulses, deviations from the ideal signal shape are quantified and subsequently taken into account.

## Revendications

1. Dispositif de détection d'impulsions de signaux (2) dans un signal de mesure analogique (1) d'un compteur de particules, le dispositif présentant un convertisseur A/N (6) et une unité d'évaluation (10), l'unité d'évaluation (10) présentant une unité d'évaluation de pente (16) qui détermine en temps réel des impulsions de signaux (2) en évaluant les pentes entre des échantillonnages voisins (8) dans le flux de données numériques (7) du convertisseur A/N (6), **caractérisé en ce que** l'unité d'évaluation (10) présente une unité de détection de dérive qui détermine et évalue des critères de détection et/ou d'évaluation du comportement de dérive du signal de mesure (1).

2. Dispositif selon la revendication 1, **caractérisé en ce que** le convertisseur A/N (6) crée le flux de données numériques (7) avec une fréquence d'échantillonnage (fₛ) supérieure à 50 MSPS, de préférence dans la plage comprise entre 50 et 105 MSPS.

3. Dispositif selon la revendication 1 ou 2, **caractérisé en ce que** la détection d'impulsions de signaux (2) est mise en œuvre dans un circuit intégré, de préférence un réseau prédiffusé programmable par l'utilisateur (11).

4. Dispositif selon l'une des revendications 1 à 3, **caractérisé en ce que** l'unité d'évaluation (10) présente une unité de détection (17) qui détecte une impulsion de signal (2) lorsqu'une séquence d'échantillonnages (8) remplit les conditions d'un ensemble de paramètres, l'ensemble de paramètres comprenant au moins un paramètre choisi parmi la pente minimale de flanc (min_incr), la durée minimale de pente (peak_valid) et/ou la descente minimale de flanc (min_decr).

5. Dispositif selon l'une des revendications 1 à 4, **caractérisé en ce que** l'unité d'évaluation (10) présente une unité de seuil (18) qui exclut des échantillonnages (8) de l'évaluation lorsqu'un seuil de détection défini (thrhld) n'est pas atteint.

6. Dispositif selon l'une des revendications 1 à 5, **caractérisé en ce que** les critères de détection et/ou d'évaluation du comportement de dérive comprennent un changement (V_{comp}) de la lumière de fond, une amplitude moyenne d'impulsion de signal (Aₚₑₐₖ) et/ou une durée moyenne d'impulsion de signal (Tₚₑₐₖ).

7. Dispositif selon l'une des revendications 1 à 6, **caractérisé en ce que** le dispositif présente un élément de compensation (5) servant à compenser un comportement de dérive dans le compteur de particules, une grandeur réglée (V_{comp}) de l'élément de compensation (5) servant à détecter et/ou à évaluer le comportement de dérive du signal de mesure (1) étant transmise à l'unité d'évaluation (10).

8. Utilisation d'un dispositif selon l'une des revendications 1 à 7, **caractérisée en ce qu'**un temps de maintenance est déterminé sur la base d'un comportement de dérive.

9. Procédé de détection d'impulsions de signaux (2) dans un signal de mesure analogique (1) au moyen d'un dispositif selon l'une des revendications 1 à 7, **caractérisé en ce que** l'unité d'évaluation (10) détermine en temps réel des impulsions de signaux (2) en évaluant les pentes entre des échantillonnages voisins (8) dans le flux de données numériques (7) du convertisseur A/N (6), des critères de détection et/ou d'évaluation du comportement de dérive du signal de mesure (1) étant déterminés et évalués.

10. Procédé selon la revendication 9, **caractérisé en ce qu'**une impulsion de signal (2) est détectée lorsqu'une séquence d'échantillonnages (8) remplit les conditions d'un ensemble de paramètres, l'ensemble de paramètres comprenant au moins un paramètre choisi parmi la pente minimale de flanc (min_incr), la durée minimale de pente (peak_valid) et/ou la descente minimale de flanc (min_decr).

11. Procédé selon la revendication 9 ou 10, **caractérisé en ce que** les échantillonnages (8) ne sont évalués que lorsqu'un seuil de détection défini (thrhld) est dépassé.

12. Procédé selon l'une des revendications 9 à 11, **caractérisé en ce que** les critères de détection et/ou d'évaluation du comportement de dérive comprennent un changement (V_{comp}) de la lumière de fond, une amplitude moyenne d'impulsion de signal (Aₚₑₐₖ) et/ou une durée moyenne d'impulsion de signal (Tₚₑₐₖ).

13. Procédé selon l'une des revendications 9 à 12, **caractérisé en ce que** le rapport minimal de la durée moyenne d'impulsion de signal (Tₚₑₐₖ) à l'intervalle d'échantillonnage (tₛ) est inférieur à 40, de préférence inférieur à 20 et en particulier inférieur à 6.

14. Procédé selon l'une des revendications 9 à 13, **caractérisé en ce que** les écarts par rapport à la forme idéale de signal sont quantifiés et ensuite pris en compte pour la détection d'impulsions de signaux se chevauchant partiellement.
